# EUROPÄISCHE PATENTSCHRIFT

(11) **EP 2 053 697 B1**
(45) Veröffentlichungstag und Bekanntmachung des Hinweises auf die Patenterteilung: **03.05.2017**
(21) Anmeldenummer: 08018378.3
(22) Anmeldetag: 21.10.2008
(51) Int. Cl.: H01R 9/26, H01R 13/658, H05K 7/14

(54) **T-förmiger geschirmter Bus-Verbinder**
T-shaped shielded bus connector
Connecteur de bus blindé en forme de T

(30) Priorität: 23.10.2007 DE 102007050943
(43) Veröffentlichungstag der Anmeldung: 29.04.2009
(73) Patentinhaber: Phoenix Contact GmbH & Co. KG, 32825 Blomberg (DE)
(72) Erfinder: Weiß, Dominik, 31855 Aerzen (DE); Grewe, Stephan, 32657 Lemgo (DE); Derksen, Johann, 33034 Brakel (DE); Thuer, Winfried, 32839 Steinheim (DE)
(74) Vertreter: Bill, Burkart Hartmut

(56) Entgegenhaltungen:
- EP-A1- 1 607 810
- DE-A1- 3 740 290
- DE-A1- 19 610 559
- DE-A1- 19 642 953
- DE-C1- 4 331 143
- DE-C1- 19 838 493

## Beschreibung

Die Erfindung betrifft einen T-förmigen Bus-Verbinder, der an einer Trägereinrichtung anzuordnen ist und eine Halteeinrichtung zum mechanischen Halten des Verbinders an der Trägereinrichtung umfasst.

Bekannt sind elektronische Baugruppen zum Steuern von Prozessen, welche über rückseitige Steckverbinderelemente an Steckverbinderelemente von Bus-Sockel-Modulen anschließbar sind, die in einer Normprofil-Tragschiene befestigbar sind und die Abschnitte der Leitungen eines Busses aufweisen, die mit den Abschnitten der Leitungen des Busses auf beiderseits benachbarten Bus-Sockel-Modulen mittels Messer- und Federleisten verbindbar sind, z.B. gemäß der DE 37 40 290 C2. Die dort vorgesehenen Messer- und Federleisten sind jedoch jeweils in Richtung der Normprofil-Tragschiene blickend oder in die entgegengesetzte Richtung blickend am Bus-Sockel-Modul angeordnet, so dass die Bus-Sockel-Module jeweils von der Vorderseite der Normprofil-Tragschiene aus zu montieren und miteinander zu verbinden sind. Die Leitungen des Busses werden durch die Normprofil-Tragschiene lediglich in gewissem Umfang gegen elektromagnetische Störungen abgeschirmt.

Weiterhin sind Bus-Verbinder oder Bus-Sockel-Module bekannt, die jeweils zwei benachbarte Baugruppen miteinander verbinden, beispielsweise gemäß DE 198 05 065 A1. Ein wesentlicher Nachteil bei dieser Lösung ist, dass die Baugruppen selbst als Busplatinenverdrahtung dienen und dass sowohl die Bussignale als auch die Spannungsversorgung unterbrochen sind, sobald eine Baugruppe entfernt wird.

Ferner sind beispielsweise aus der EP 0 527 247 B1 U-förmige Bus-Verbinder bekannt, bei denen die Bus-Verbinder derart an den Baugruppen angeordnet sind, dass beim Zusammenbau der Baugruppen benachbarte Baugruppen zwangsweise elektrisch leitend miteinander verbunden werden. Auch bei der dort offenbarten Ausgestaltung ist sowohl die Datenleitung als auch die Spannungsversorgung unterbrochen sobald man eine Baugruppe abzieht. Spezielle Schirmungen sind beiden vorgenannten Druckschriften nicht zu entnehmen.
Beschrieben sind beispielsweise gemäß DE 195 15 538 oder DE 195 24 123 ferner Baugruppen, die mittels Leiter in Form von Schienen, verbunden sind.

Schließlich ist beispielsweise ein T-förmiger Bus-Verbinder gemäß EP 0 896 504 B1 bekannt, der als Bus-Sockel-Modul für eine oder mehrere Baugruppen dienen kann. Dieser Bus-Verbinder besitzt drei Steckverbinder, die jedoch direkt über Metallkontakte miteinander verbunden sind.

T-förmige Busverbinder mit auf Leiterplatten angeordneten Verbindungseinrichtungen sind aus den Dokumenten DE 196 10 559 A1, EP 1607 810 A1 und DE 198 38 493 C1 bekannt, welch letzteres die Merkmale des Oberbegriffs von Anspruch 1 zeigt.

Ein Nachteil bei den bekannten Bus-Sockel-Modulen bzw. Bus-Verbindern besteht insbesondere darin, dass zukünftige Herausforderungen sich häufig nicht mehr mit diesen Lösungen meistern lassen. Zum Einen werden die Datensignale zukünftig immer schneller und der Hochfrequenzanteil dadurch immer größer, woraus gleichzeitig eine stärkere Störaussendung resultiert. Zum Anderen werden gleichzeitig jedoch die Signalpegel immer kleiner und die Störbeeinflussung von außen werden folglich relativ immer größer. Ferner reagieren auch die Leitungstreiber, die für höhere Datenraten geeignet sind, empfindlicher auf Gleichtaktstörungen.

Eine Aufgabe der Erfindung ist folglich darin zu sehen, einen gattungsgemäßen Bus-Verbinder bzw. ein Bus-Sockel-Modul derart weiter zu bilden, dass die elektromagnetische Verträglichkeit wesentlich verbessert wird. Weitere Aufgaben der Erfindung sind insbesondere darin zu sehen, die Einsatzmöglichkeit und Flexibilität derartiger Bus-Verbinder zu erhöhen.

Erfindungsgemäße Lösungen sind Gegenstand der anhängigen Ansprüche, wobei vorteilhafte und/oder bevorzugte Ausführungsformen und Weiterbildungen Gegenstand der abhängigen Ansprüche sind.

Die Erfindung sieht folglich einen T-förmigen Bus-Verbinder nach Ansrpuch 1 vor.

Hierdurch lassen sich auf einfachste Weise eine Anzahl von T-förmigen Bus-Verbindern, nachfolgend auch als Bus-Sockel-Module bezeichnet, zu einem Rückwandbus aneinanderreihen, der äußerst vorteilhaft elektrische oder elektronische Baugruppen über die einzelnen T-förmigen Bus-Verbinder an das Bussystem anschließt und darüber hinaus im Wesentlichen umlaufend geschirmt ist.

Weitere Merkmale und Vorteile der Erfindung ergeben sich aus der nachfolgenden beispielhaften Beschreibung einiger Ausführungsformen nach der Erfindung unter Bezugnahme auf die beigefügten Zeichnungen. In den Zeichnungen zeigen:
- Fig. 1: schematisiert eine auf einer Tragschiene aufgerastete erste Ausführungsform eines T-förmigen Bus-Verbinders gemäß der Erfindung,
- Fig. 2: schematisiert eine der Fig. 1 ähnliche zweite Ausführungsform eines T-förmigen Bus-Verbinders gemäß der Erfindung,
- Fig. 3: schematisiert einen Längsschnitt durch die Ausführungsform gemäß Fig. 2,
- Fig. 4: schematisiert eine Anordnung von zwei, jeweils mit einer Baugruppe bestückten T-förmigen Bus-Verbindern nach Fig. 2,
- Fig. 5: schematisiert einen Längsschnitt durch die Anordnung gemäß Fig. 4,
- Fig. 6a: schematisiert ein erstes Beispiel einer Busleitungsführung zwischen einer Anordnung von, jeweils mit einer Baugruppe bestückten T-förmigen Bus-Verbindern gemäß der Erfindung,
- Fig. 6b: schematisiert ein zweites Beispiel einer Busleitungsführung zwischen einer Anordnung von, jeweils mit einer Baugruppe bestückten T-förmigen Bus-Verbindern gemäß der Erfindung,
- Fig. 6c: schematisiert ein drittes Beispiel einer Busleitungsführung zwischen einer Anordnung von, jeweils mit einer Baugruppe bestückten T-förmigen Bus-Verbindern gemäß der Erfindung,
- Fig. 6d: schematisiert ein viertes Beispiel einer Busleitungsführung zwischen einer Anordnung von, jeweils mit einer Baugruppe bestückten T-förmigen Bus-Verbindern gemäß der Erfindung,
- Fig. 7: schematisiert ein nicht von der Erfindung umfasstes Beispiel eines T-förmigen Bus-Verbinders,
- Fig. 8: schematisiert einen Längsschnitt durch das Beispiel gemäß Fig. 7,
- Fig. 9: schematisiert einen Längsschnitt durch eine Anordnung von zwei, jeweils mit einer Baugruppe bestückten T-förmigen Bus-Verbindern nach Fig. 7.

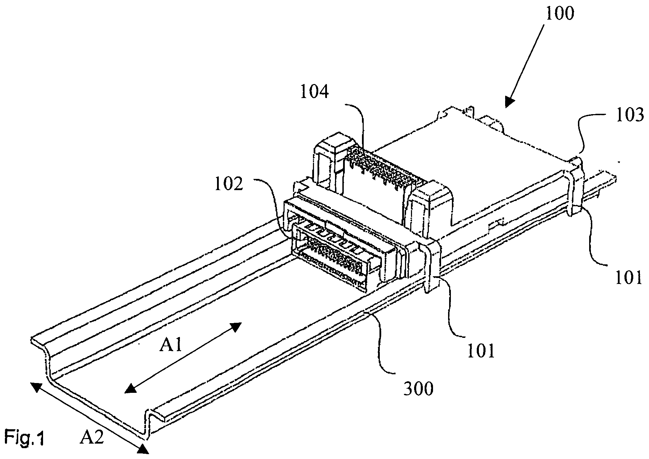

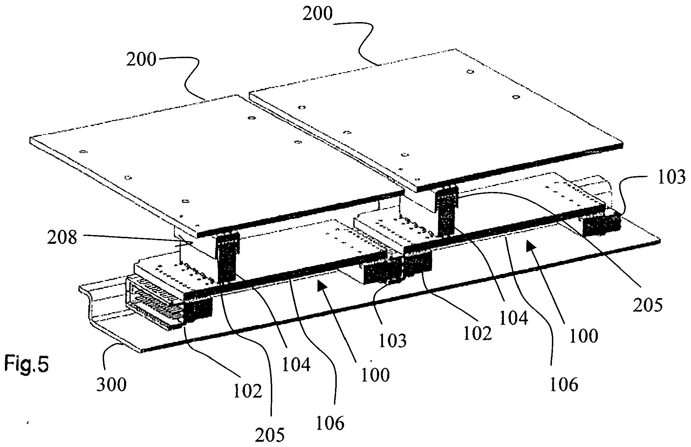

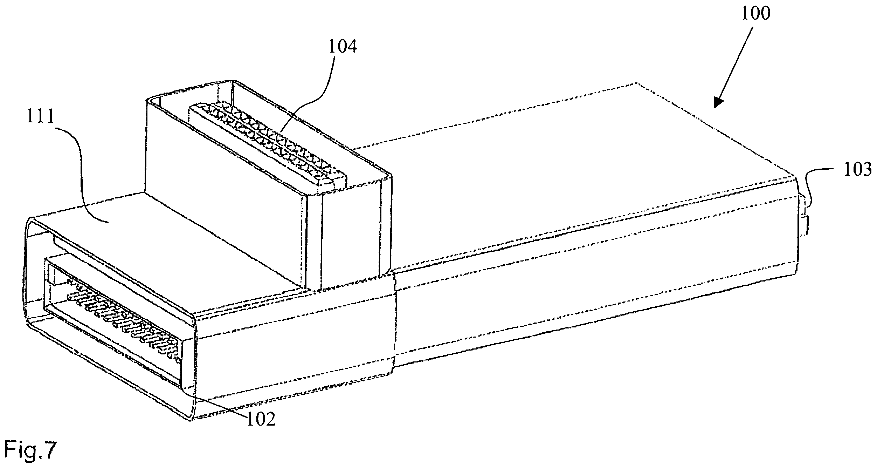

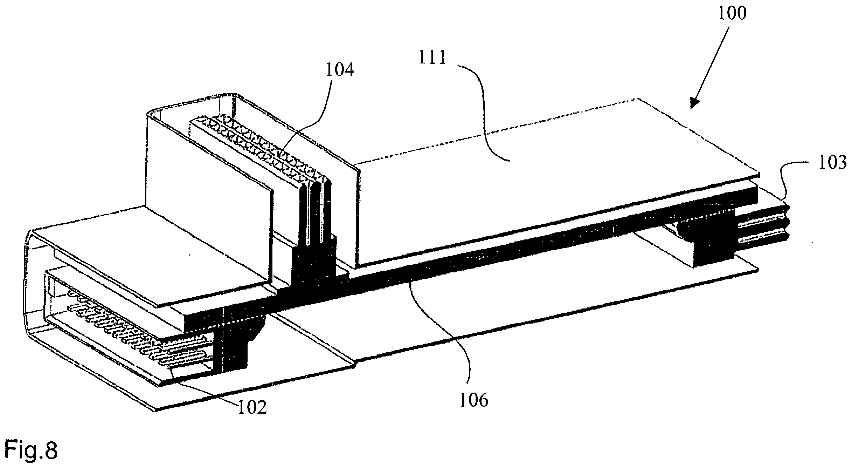

Nachfolgend wird zunächst auf die Figuren 1 bis 5 und 7 bis 9 Bezug genommen, welche nicht von der Erfindung umfasste Beispiele (Figuren 7 bis 9) und beispielhafte Anordnungen von mehreren, jeweils mit einer elektrischen oder elektronischen Baugruppe bestückten T-förmigen Bus-Verbindern zeigen.

Je Baugruppe 200 ist ein Bus-Sockel-Modul bzw. Bus-Verbinder 100 vorgesehen. In den Figuren sind die elektrischen oder elektronischen Baugruppen 200 lediglich angedeutet und können z.B. daran angeschlossene Sensoren oder Aktoren umfassen, werden jedoch nicht weiter ausgeführt.

Jeder Bus-Verbinder 100 besitzt eine Halteeinrichtung zum mechanischen Halten des Bus-Verbinders an einer Trägereinrichtung 300, an welcher der Bus-Verbinder zur Inbetriebnahme anzuordnen ist. Bei den in den Figuren dargestellten Beispielen ist die Trägereinrichtung 300 eine Tragschiene, auf welcher die Bus-Verbinder gemäß Fign. 1, 4, 5 und 9 zur Inbetriebnahme aufgerastet und zweckmäßig zum Ausrichten mit benachbarten Bus-Verbindern auf der Tragschiene 300 verschoben werden kann. Bei Fig. 1 sind hierfür zwei Haltearme mit jeweils beidseitig der Längsachse (Bezugszeichen A1 in Fig. 1) der Tragschiene 300 angeordneten federnden Rasthaken 101 vorgesehen, welche die Tragschiene umgreifen und das Verschieben des Bus-Verbinders 100 und auch ein einfaches Lösen des Bus-Verbinders 100 auf bzw. von der Tragschiene ermöglichen. Je nach spezifischer Ausführung können bereits auch zwei die Tragschiene umgreifende Rasthaken oder andere Halteeinrichtungen zum sicheren Halten eines erfindungsgemäßen Bus-Verbinders an einer Trägereinrichtung ausreichen bzw. vorgesehen sein. Bis auf Fig. 1 sind jeweilige Halteeinrichtungen aus Gründen der Übersichtlichkeit nicht dargestellt.

Jeder Bus-Verbinder 100 gemäß der Erfindung ist als T-förmiger Bus-Verbinder bzw. T-förmiges Bus-Sockel-Modul ausgebildet. Die T-förmige Struktur ergibt sich dadurch, dass jeder Bus-Verbinder eine erste und eine zweite Verbindungseinrichtung 102 bzw. 103 aufweist, die in einander entgegengesetze Richtungen blicken, bei Verwendung einer Tragschiene 300 zweckmäßig jeweils entlang der Längsachse der Tragschiene blickend, und zueinander komplementär ausgebildet sind sowie eine zur ersten und zur zweiten Verbindungseinrichtung im Wesentlichen senkrecht ausgerichtete dritte Verbindungseinrichtung 104, die im montierten Zustand eines Bus-Verbinders in eine von der Trägereinrichtung entgegengesetzte Richtung blickt.

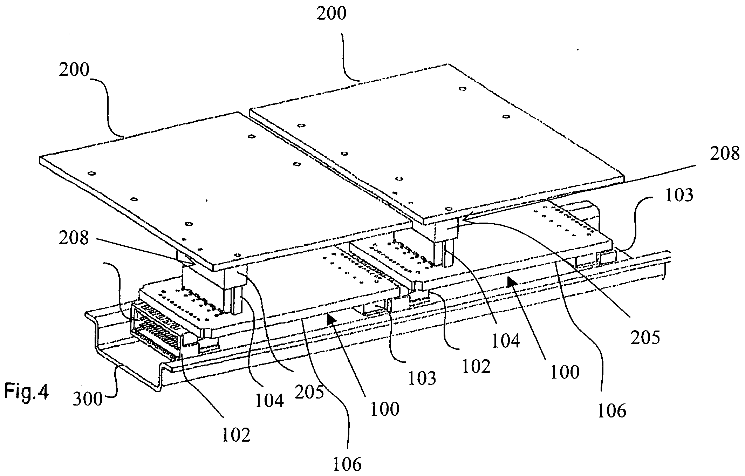

Die erste und zweite Verbindungseinrichtung 102 bzw. 103 dienen zum jeweiligen Herstellen einer elektrischen Verbindung mit einer zur ersten bzw. zweiten Verbindungseinrichtung komplementären Verbindungseinrichtung einer zum Bus-Verbinder benachbart angeordneten Einrichtung und ermöglichen so auf einfache Weise das Aneinanderreihen einer Vielzahl von T-förmigen Bus-Verbindern wie bei den Figuren 4, 5 und 9 zu sehen. Über die dritte Verbindungseinrichtung 104 wird die elektrische Verbindung mit jeweils einer zur dritten Verbindungseinrichtung 104 komplementären Verbindungseinrichtung 205 einer elektrischen oder elektronischen Baugruppe 200 hergestellt. Wie in den Fign. 4, 5 und 9 zu sehen, befindet sich jeweils ein Bus-Sockel-Modul 100 unter jeweils einer Baugruppe 200. Da die Verbindungseinrichtungen 104 im montierten Zustand eines Bus-Verbinders in die von der Trägereinrichtung abgewandte Richtung und also in Richtung der Baugruppen-Unterseiten blicken, sind die zu diesen komplementär ausgebildeten Verbindungseinrichtungen 205 an den Baugruppen-Unterseiten angeordnet.

Bei den in den Figuren dargestellten Ausführungsformen weisen alle Verbindungseinrichtungen 102, 103, 104 und 205 eine im wesentlichen rechteckförmige Grundform auf, wobei sich die jeweils größeren Außenflächen entlang der Querachse A2 (Fig. 1) der Tragschiene 300 erstrecken, und die Verbindungseinrichtungen 102 und 205 besitzen zum Kontaktieren jeweils eine Messerleiste und die hierzu jeweils komplementär ausgebildete Verbindungseinrichtung 103 bzw. 104 eine zur Messerleiste komplementäre und mit dieser zusammensteckbare Federleiste.

Alle drei Verbindungsleisten 102, 103 und 104 eines Bus-Verbinders 100 sind bevorzugt über eine Leiterplatte 106 in ihrer Position gehalten, welche ferner Daten- und Energie-Busleitungen beinhaltet, die applikationsspezifisch zwischen den Verbindungsleisten 102, 103 und 104 geführt sind und somit nach jeweiliger Verbindungsherstellung von zwei komplementären Verbindungseinrichtungen an diesen die Übertragung von Daten- und/oder Energiesignale in gewünschter Weise bereitstellen.

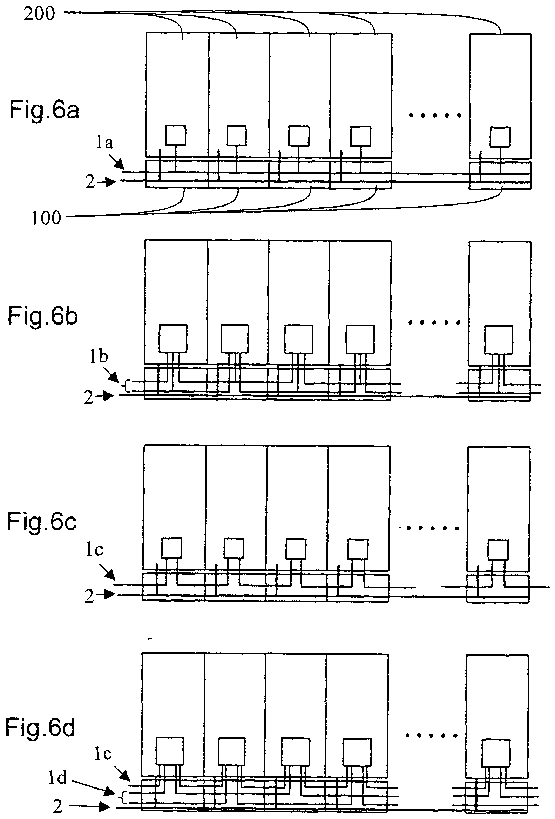

Die Fign. 6a bis 6d zeigen verschiedene Beispiele von bevorzugten Busleitungsführungen zwischen einer Anordnung von, jeweils mit einer Baugruppe 200 bestückten T-förmigen Bus-Verbindern 100 bzw. Bus-Sockel-Modulen gemäß der Erfindung. Je nach spezifisch aufgebauter Leitungsplatte kann somit im Bus-Sockel-Modul z.B. eine gemeinsame Versorgungsspannung für alle Baugruppen bzw. auch daran angeschlossene Sensoren und Aktoren sowie das zugehörige Massepotential mitgeführt werden, wie in den Fig. 6a bis 6d durch die mit der Bezugsziffer 2 gekennzeichneten Leitungsführung dargestellt. Ferner können die benötigten Datensignale applikationsspezifisch unterschiedlich über entsprechend angepasste Busleitungsstrukturen geführt sein, wie dies beispielhaft in den Fig. 6a bis 6d durch die mit den Bezugsziffern 1a bis 1d gekennzeichneten Leitungsführungen dargestellt ist. So stellt die Leitungsführung 1a nach Fig. 6a eine Leitungsführung dar, gemäß welcher die Datensignale als gemeinsamer Bus jeweils an allen dritten Verbindungseinrichtungen anliegen und somit alle Baugruppen über diese Leitungsführung verbunden sind. Gemäß den zwei Leitungsführungen 1b nach Fig. 6b liegen die darüber geführten Datensignale jeweils nur an den dritten Verbindungseinrichtungen von Gruppen aus jeweils drei unmittelbar aneinander gereihten Bus-Verbindern und den daran angeschlossenen Baugruppen an, so dass jeweils Gruppen von Baugruppen über eine gemeinsame Leitungsführung miteinander verbunden sind. Gemäß Leitungsführung 1c nach Fig. 6c werden immer nur die dritten Verbindungseinrichtungen von zwei unmittelbar aneinander gereihten Bus-Verbindern in Art einer Punkt-zu-Punkt-Verbindung miteinander verbunden, so dass die darüber geführten Datensignale jeweils zwei Baugruppen in Form einer "Daisy Chain" verbinden. Gemäß der kombinierten Leiterführung 1c und den zwei Leitungsführungen 1d nach Fig. 6d werden über die Leitungsführung 1c wieder jeweils zwei Baugruppen in Form einer "Daisy Chain" mit einander verbunden und mittels der zwei Leitungsführungen 1d jeweils bestimmte Baugruppen überbrückt.

Der bevorzugte Einsatz von Leiterplatten mit applikationsspezifisch darin oder daran ausgebildeten Daten- und Energie-Busleitungen zwischen den ersten, zweiten und dritten Verbindungseinrichtungen 102, 103 und 104 ermöglicht über die Bus-Sockel-Module 100 somit eine elektrische Anbindung von Baugruppen an das Bussystem, welche auch einen Baugruppentausch während des Betriebs zulässt ohne die Datenverbindung zu unterbrechen. Die mittels der Leitungen bereitgestellten Datensignalverbindungen können hierbei als jeweils getrennte Sende- und Empfangsverbindungen ausgeführt sein oder auch als gemeinsame bidirektionale Verbindungen.

Mit den vorbeschriebenen Verbindungseinrichtungen, deren Positionierungen und deren, in zweckmäßiger Weise unter Verwendung der Leiterplatten, bereitgestellten Leitungsverbindungen müssen die Verbindungseinrichtungen 205 der elektronischen oder elektrischen Baugruppen nicht mehr als Busplatinenverdrahtung herhalten und die einzelnen Baugruppen müssen nicht mehr zwangsweise abwechselnd miteinander verbunden sein, so dass die Bus-Sockel-Moduls nach der Erfindung äußerst flexibel einsetzbar sind.

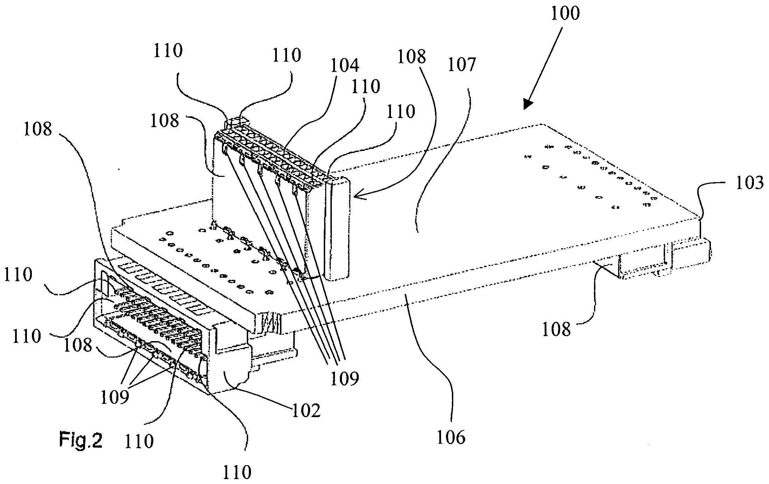

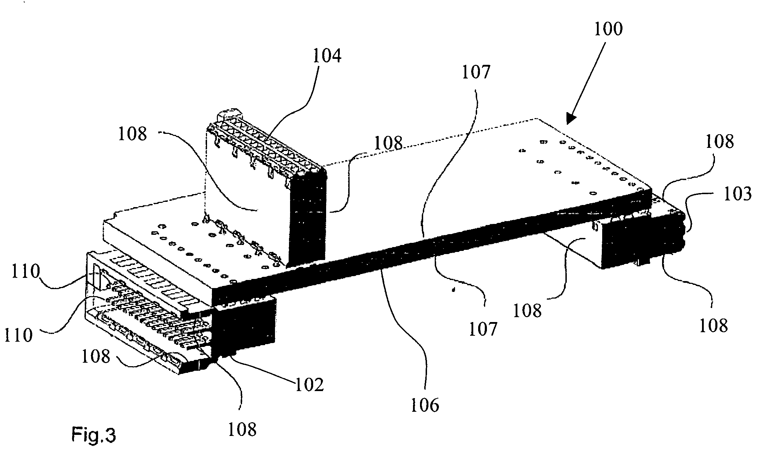

Zur Erhöhung der elektromagnetischen Verträglichkeit sind alle drei Verbindungseinrichtungen 102, 103 und 104 des T-förmigen Bus-Verbinders 100 zumindest teilweise mit einem Schirmungsmaterial derart umgeben, dass das Schirmungsmaterial jeder dieser Verbindungseinrichtungen bei Verbindung mit einer jeweils komplementär ausgebildeten Verbindungseinrichtung ein diese komplementäre Verbindungseinrichtung zumindest teilweise umgebendes Schirmungsmaterial kontaktiert. Die Verbindungseinrichtung 205 einer elektronischen oder elektrischen Baugruppen 200 ist folglich in bevorzugter Ausführung ebenfalls mit einem Schirmungsmaterial umgeben, welches das die Verbindungseinrichtung 104 zumindest teilweise umgebende Schirmungsmaterial bei Zusammenführen beider Verbindungseinrichtungen kontaktiert. Zweckmäßig ist ferner die Leiterplatte 106 zumindest hinsichtlich deren beiden äußeren Lagen 107 (Fign. 2, 3) ebenfalls geschirmt.

Für die Bereitstellung und Anordnung entsprechender Abschirmung werden nachfolgend einige im Rahmen der Erfindung liegende, wiederum unter Bezugnahme auf die Figuren, insbesondere auf die Fign. 2, 3, 7 und 8, beschrieben.

Im Fall der in den Figuren dargestellten, im Wesentlichen rechteckförmig ausgebildeten steckbaren Verbindungseinrichtungen 102, 103,104 und 205 ist gemäß einer ersten bevorzugten Ausführungsform zur Ausbildung der erfindungsgemäßen Schirmung vorgesehen, alle drei Verbindungseinrichtungen 102, 103 und 104 des Bus-Sockel-Moduls 100 zumindest an den beiden größeren Außenflächen komplett mit einem Schirmblech zu schirmen, in den Figuren teilweise mit 108 gekennzeichnet, und in diesem Fall zweckmäßigerweise auch die Verbindungseinrichtung 205 an der einem jeweiligen Bus-Sockel-Modul 100 zugewandten Seite einer Baugruppe 200 ebenfalls mindestens an den beiden größeren Außenflächen komplett mit einem Schirmblech zu schirmen, in den Figuren teilweise mit 208 gekennzeichnet. Die Schirmflächen 108 und 208 der Steckverbinder sind so gestaltet, dass diese mit ihrem Gegenstück im gesteckten Zustand auf der ganzen Länge, also entlang der in Fig. 1 gekennzeichneten Querachse A2, viele Kontakte in geringem Abstand zueinander haben. Hierzu können am Schirmblech 108 und 208 Kontaktfedern, wie zum Beispiel bei Fig. 2 deutlich zu sehen und mit der Bezugsziffer 109 belegt, angeordnet sein, welche alternativ beispielsweise auch Noppen, angepresste Flächen o.ä. ausgeführt sein können. Diese Schirmflächen 108 bzw. 208 sind jeweils mindestens einmal mit Masse oder einem anderen geeigneten Potential, z.B. mit einem geeigneten Potential der Leiterplatte 106 verbunden.

Die kürzeren Außenseiten bzw. kleineren Außenflächen der Steckverbinder 102, 103, 104 und 205 können in diesem Fall ebenfalls mit Schirmflächen versehen sein. Sollte dies applikationsspezifisch nicht möglich sein, sind gemäß einer zweckmäßigen Alternative die außenliegenden Pins, d.h. die benachbart zur jeweils kürzeren Außenseite angeordneten Pins der Steckverbinder, in den Fign. 2 und 3 teilweise mit der Bezugsziffer 110 gekennzeichnet, mit Masse oder einem geeigneten Potential belegt. In weiterer alternativer Ausführung können auch innenliegende Pins zur Schirmung genutzt werden, so lange die Datensignale von Massepins eingeschlossen sind.
Wie bereits erwähnt ist in dem Fall einer in den Bus-Sockel-Modulen verwendeten Platine 106, diese zumindest in den beiden äußeren Lagen 107, welche die größten Außenflächen bereitstellen, ebenfalls komplett geschirmt.

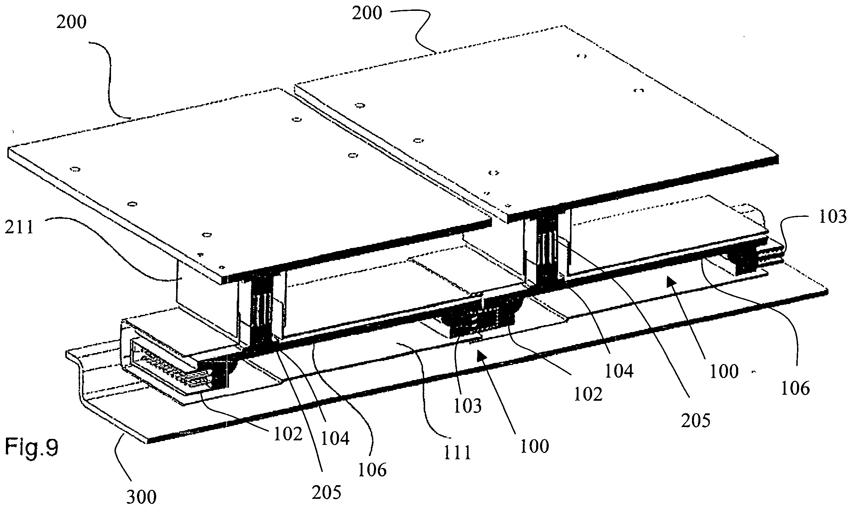

Gemäß den Figuren 7 bis 9 ist ein nicht von der Erfindung umfasstes Beispiel der Schirmung dargestellt. Bei diesem Beispiel ist die Schirmung dadurch bewirkt, dass mindestens ein elektrisch leitfähiges Gehäuseteil 111 die Leiterplatte 106 umschließt. Das elektrisch leitfähige Gehäuseteil 111 umschließt ferner alle drei Steckverbinder 102, 103 und 104 und besitzt rund um diese Steckverbinder auf der gesamten Länge wiederum viele Kontaktstellen in geringem Abstand zueinander, die das leitfähige Gehäuseteil 111 des jeweils benachbarten Bus-Sockel-Moduls 100 bzw. eine den Steckverbinder 205 auf der Rückseite der Baugruppe 200 umschließende Schirmung 211, wie bei Fig. 9 zu sehen, kontaktieren.

In weiteren applikationsspezifisch zweckmäßigen, jedoch in den Figuren nicht dargestellten Beispielen kann die Schirmung z.B. auch dadurch ausgeführt sein, dass mindestens ein Schirmblech die Leiterplatte eines Bus-Sockel-Moduls von mindestens einer Seite herkommend umschließt, wobei bei einem solchen Schirmblech der Schirm dann durch eine Außenlage der Leiterplatte geschlossen wird. Das Schirmblech eines Bus-Sockel-Moduls ist wiederum rund um die Steckverbinder so dimensioniert und besitzen wiederum rund um die Steckverbinder auf der ganzen Länge viele Kontakte in geringem Abstand zueinander, dass das Schirmblech eines ersten Bus-Sockel-Moduls die jeweiligen Schirmbleche von mit dem ersten Bus-Sockel-Modul verbundenen benachbarten zweiten Bus-Sockel-Modulen und ein Schirmblech um den Steckverbinder auf der Rückseite von einer mit dem ersten Bus-Sockel-Modul verbundenen Baugruppe kontaktiert.

Gemäß einem weiteren in den Figuren nicht dargestellten Beispiel kann die Schirmung z.B. dadurch realisiert sein, dass das Bus-Sockel-Modul in einem Kunststoffgehäuse beherbergt ist, welches derart mit Metall beschichtet ist, dass die Metallisierung umlaufend einen Schirm darstellt, und um die Steckverbinder wieder so dimensioniert ist und auf der ganzen Länge wiederum viele Kontakte in geringem Abstand zueinander besitzt, dass eine Metallisierung bzw. ein Schirmblech um den Steckverbinder auf der Rückseite von einer mit dem Bus-Sockel-Modul verbundenen Baugruppe und die Metallisierung eines benachbarten Bus-Sockel-Moduls kontaktiert wird.
Insbesondere bei Schirmungsausführungen unter Verwendung von Gehäusen oder Gehäuseteilen kann alternativ zu und anstelle von einer Leiterplatte mit Steckverbindern auch eine Anordnung von Leitern mit Kontakten verwendet werden, wie sie beispielsweise bei der in der EP 0 896 504 offenbarten Bus-Verbinder-Ausführung verwendet wird. Basierend auf den vorstehend beispielhaft beschriebenen Schirmungen ist somit nach der Erfindung bevorzugt der gesamte, aus den einzelnen Bus-Sockel-Modulen aufgebaute Rückwandbus umlaufend geschirmt.

Die zumindest teilweise eine jeweilige Verbindungseinrichtung umgebende Schirmung ist hierzu nach der Erfindung in besonders zweckmäßiger Weise um die jeweilige Verbindungseinrichtung so dimensioniert, dass um diese Verbindungseinrichtung herum die Schirmung jeweils komplementär zu der Schirmung einer mit dieser Verbindungseinrichtung zu koppelnden komplementären Verbindungseinrichtung ist.

Bei den vorstehend beschriebenen Ausführungsformen kann das Schirmungsmaterial der jeweiligen Schirmungen auch z.B. mit Funktionserde oder mit einem anderen freien Potential verbunden sein oder mit einem anderen geeigneten Potential, welches direkt oder über einen Widerstand und/oder einen Kondensator mit Masse oder Funktionserde verbunden ist.

Es versteht sich, dass die vorstehend beschriebenen Merkmale nicht nur in der jeweils angegebenen Kombination, sondern auch in anderen Kombinationen oder in Alleinstellung verwendbar sind, sofern nicht ausdrücklich anders angezeigt, ohne hierdurch den Rahmen der vorliegenden Erfindung zu verlassen.

## Patentansprüche

1. T-förmiger Bus-Verbinder, umfassend
eine Halteeinrichtung zum mechanischen Halten des T-förmigen Bus-Verbinders an einer Trägereinrichtung, an welcher der T-förmige Bus-Verbinder anzuordnen ist, eine erste und eine zweite Verbindungseinrichtung (102, 103) zum jeweiligen Herstellen einer elektrischen Verbindung mit einer komplementären Verbindungseinrichtung einer zum Bus-Verbinder benachbart angeordneten Einrichtung,
wobei die erste und die zweite Verbindungseinrichtung in einander entgegengesetzte Richtungen blicken und zueinander komplementär ausgebildet sind,
sowie eine zur ersten und zur zweiten Verbindungseinrichtung im Wesentlichen senkrecht ausgerichtete dritte Verbindungseinrichtung (104) zum Herstellen einer elektrischen Verbindung mit einer zur dritten Verbindungseinrichtung komplementären Verbindungseinrichtung (205) einer elektrischen oder elektronischen Baugruppe (200),
wobei zwischen allen drei Verbindungseinrichtungen Daten- und/oder Energie-Busleitungen geführt sind,
wobei alle drei Verbindungseinrichtungen (102, 103 und 104) über eine Leiterplatte in ihrer Position gehalten sind, welche ferner die Daten- und/oder Energie-Busleitungen zwischen allen drei Verbindungseinrichtungen führt, **dadurch gekennzeichnet, dass** alle drei Verbindungseinrichtungen des T-förmigen Bus-Verbinders zumindest teilweise mit einem Schirmungsmaterial umgeben ist, und das Schirmungsmaterial jeder der drei Verbindungseinrichtungen bei Verbindung mit einer jeweils komplementär ausgebildeten Verbindungseinrichtung ein diese komplementäre Verbindungseinrichtung zumindest teilweise umgebendes Schirmungsmaterial kontaktieren kann und dass die vom Bus-Verbinder umfasste Leiterplatte, ohne dass diese von einem elektrisch leitfähigen Gehäuseteil oder metallbeschichtetem Kunststoffgehäuse umschlossen ist, zumindest in Bezug auf deren beiden äußeren Lagen komplett geschirmt ist, und das Schirmungsmaterial jeder der drei Verbindungseinrichtungen mit einem geeigneten Potential der Leiterplatte verbunden ist.

2. T-förmiger Bus-Verbinder nach Anspruch 1, wobei das zumindest teilweise eine jeweilige Verbindungseinrichtung umgebende Schirmungsmaterial um die jeweilige Verbindungseinrichtung so dimensioniert ist, dass um diese Verbindungseinrichtung herum das Schirmungsmaterial jeweils komplementär zu dem Schirmungsmaterial einer mit dieser Verbindungseinrichtung zu koppelnden komplementären Verbindungseinrichtung ist.

3. T-förmiger Bus-Verbinder nach einem der vorstehenden Ansprüche, wobei die Schirmungsmaterialien mit einer Vielzahl von Kontaktstellen gestaltet sind, die bei Verbindung einer Verbindungseinrichtung mit einer jeweils komplementär ausgebildeten Verbindungseinrichtung ein gegenseitiges Kontaktieren in geringem Abstand und im Wesentlichen über die gesamte Länge zwischen zwei Schirmungsmaterialien bewirken.

4. T-förmiger Bus-Verbinder nach einem der vorstehenden Ansprüche, wobei die erste oder zweite Verbindungseinrichtung eine elektrisch leitfähige Messerleiste bzw. Federleiste ist und die dritte Verbindungseinrichtung eine elektrisch leitfähige Messer- oder Federleiste ist.

5. T-förmiger Bus-Verbinder nach einem der vorstehenden Ansprüche, wobei die Trägereinrichtung eine Tragschiene 300 ist und die Halteeinrichtung wenigsten zwei federnde Rasthaken zum verschiebbaren und wieder lösbaren Halten des Verbinders an Tragschiene umfasst.

6. T-förmiger Bus-Verbinder nach einem der vorstehenden Ansprüche, wobei die Busleitungen der Leiterplatte Daten-Busleitungen bereitstellen, die bei Anneinanderreihung einer Vielzahl von T-förmigen Bus-Verbindern nach einem der vorstehenden Ansprüche durch Verbindungen über jeweils erste und zweite Verbindungseinrichtungen Datensignale derart zwischen den ersten zweiten und dritten Verbindungseinrichtungen führen, dass über die Daten-Busleitungen geführte Datensignale jeweils an allen dritten Verbindungseinrichtungen anliegen, jeweils an den dritten Verbindungseinrichtungen einer Gruppe von unmittelbar aneinander gereihten Bus-Verbindern anliegen, jeweils an den dritten Verbindungseinrichtungen von zwei unmittelbar aneinander gereihten Bus-Verbindern anliegen und diese in Form einer "Daisy Chain" verbinden und/oder auch eine oder mehrere von dritten Verbindungseinrichtungen von aneinander gereihten Bus-Verbindern überbrücken.

7. T-förmiger Bus-Verbinder nach einem der vorstehenden Ansprüche, wobei alle drei Verbindungseinrichtungen (102, 103 und 104) rechteckförmig ausgebildet sind und zumindest an den jeweils beiden größeren Außenflächen komplett mit einem Schirmblech geschirmt sind.

8. T-förmiger Bus-Verbinder nach vorstehendem Anspruch, wobei die kürzeren Außenseiten bzw. kleineren Außenflächen aller drei Verbindungseinrichtungen ebenfalls mit Schirmflächen versehen sind oder benachbart zur jeweils kürzeren Außenseite angeordnete Pins der Verbindungseinrichtungen mit Masse oder einem geeigneten Potential belegt sind oder innenliegende Pins der Verbindungseinrichtungen mit Masse oder einem geeigneten Potential belegt sind, welche die Pins zur Führung von Datensignalen umgeben.

## Claims

1. T-shaped bus connector, comprising:
a holding device for mechanically retaining the T-shaped bus connector on a mounting device on which the T-shaped bus connector is to be arranged,
a first and a second connecting unit (102, 103) for respectively producing an electrical connection to a complementary connecting unit of a device arranged adjacent to the bus connector, wherein the first and second connecting units face in opposing directions and are constructed complementarily to one another and
a third connecting unit (104), oriented substantially perpendicular to the first and second connecting units, for producing an electrical connection to a connecting unit (205), complementary to the third connecting unit, of an electrical or electronic module (200),
wherein data and/or power bus lines are run between all three connecting units,
wherein all three connecting units (102, 103 and 104) are held in their positions by a circuit board, which additionally carries the data and/or power bus lines between all three connecting units,
**characterized in that**
all three connecting units of the T-shaped bus connector are covered at least in part with a shielding material, and the shielding material of each of the three connecting units can contact, in case of a connection of each connecting unit to a respective complementarily formed connecting unit, a shielding material at least partially covering this complementarily formed connecting unit and that
the circuit board comprised by the bus connector,
without being surrounded by an electrically conductive housing part or a plastic housing coated with metal,
is completely shielded, at least with respect to the two outer layers, and
the shielding material of each of the three connecting units is connected with a suitable potential of the circuit board.

2. T-shaped bus connector according to Claim 1, wherein the shielding surrounding a respective connecting unit at least in part is dimensioned around the respective connecting unit such that the shielding around this connecting unit is complementary to the shielding of a respective complementary connecting unit to be coupled to this connecting unit.

3. T-shaped bus connector according to one of the preceding claims, wherein the shielding materials are shaped with a plurality of contact points that, upon connection to a connecting unit with a respective complementarily constructed connecting unit, bring about mutual contacting in small intervals and substantially over the entire length between two shielding materials.

4. T-shaped bus connector according to one of the preceding claims-, wherein the first or second connecting unit is an electrically conductive male multipoint contact or female multipoint contact and the third connecting unit is an electrically conductive male multipoint contact or female multipoint contact.

5. T-shaped bus connector according to one of the preceding claims-, wherein the mounting unit is a mounting rail (300) and the retaining unit comprises at least two resilient catch hooks for movable and detachable retention of the connector on the mounting rail.

6. T-shaped bus connector according to one of the preceding claims, wherein the bus lines of the circuit board provide data bus lines which, upon concatenation of a plurality of T-shaped bus connectors according to one of the preceding claims by means of connections via respective first and second connecting units, carry data signals between the first, second and third connecting units in such a manner that data signals carried via the data bus lines are respectively present at all third connecting units, at the third connecting units of a group of directly concatenated bus connectors, and at the third connecting units of two directly concatenated bus connectors and connect them in the form of a "daisy chain" and/or also bridge one or more third connecting units of bus connectors concatenated with one another.

7. T-shaped bus connector according to one of the preceding claims, wherein all three connecting units (102, 103 and 104) are rectangular in shape and are completely shielded with a metal shield at least on the respective two larger outer surfaces.

8. T-shaped bus connector according to the preceding claim, wherein the shorter outer sides or smaller outer surface of all three connecting units are likewise furnished with shielding areas, or a ground potential or a suitable potential is applied to pins of the connecting unit that are arranged adjacent to the respective shorter outer side, or ground potential or a suitable potential is applied to inner pins of the connecting units that surround the pins for carrying data signals.

## Revendications

1. Connecteur de bus en forme de T, comprenant :
un dispositif de retenue destiné à retenir mécaniquement le connecteur de bus en forme de T sur un dispositif de support, sur lequel le connecteur de bus en forme de T doit être disposé, un premier et un deuxième dispositif de liaison (102, 103) destinés à établir respectivement une liaison électrique avec un dispositif de liaison complémentaire d'un dispositif agencé au voisinage du connecteur de bus,
le premier et le deuxième dispositif de liaison étant orientés dans des directions opposées l'une à l'autre et étant complémentaires l'un de l'autre,
ainsi qu'un troisième dispositif de liaison (104) orienté sensiblement perpendiculairement au premier et au deuxième dispositif de liaison pour établir une liaison électrique avec un dispositif de liaison (205), complémentaire du troisième dispositif de liaison, d'un module électrique ou électronique (200),
des lignes de bus de données et/ou d'énergie étant guidées entre ces trois dispositifs de liaison,
ces trois dispositifs de liaison (102, 103 et 104) étant maintenus dans leur position par une carte de circuits imprimés, laquelle guide en outre les lignes de bus de données et/ou d'énergie entre ces trois dispositifs de liaison,
**caractérisé en ce que** ces trois dispositifs de liaison du connecteur de bus en forme de T sont entourés au moins en partie par un matériau de blindage, et le matériau de blindage de chacun des trois dispositifs de liaison, lors de la liaison à un dispositif de liaison conçu de manière respectivement complémentaire, peut être en contact avec un matériau de blindage entourant au moins en partie ce dispositif de liaison complémentaire, et **en ce que** la carte de circuits imprimés entourée par le connecteur de bus, sans être entourée par une partie de boîtier électro-conductrice ou un boîtier en matière plastique revêtu de métal, est entièrement blindée au moins en ce qui concerne ses deux couches extérieures, et le matériau de blindage de chacun des trois dispositifs de liaison est relié à un potentiel adapté de la carte de circuits imprimés.

2. Connecteur de bus en forme de T selon la revendication 1, le matériau de blindage entourant au moins en partie un dispositif de liaison respectif étant dimensionné autour du dispositif de liaison respectif de sorte que, autour de ce dispositif de liaison, le matériau de blindage est respectivement complémentaire du matériau de blindage d'un dispositif de liaison complémentaire à coupler à ce dispositif de liaison.

3. Connecteur de bus en forme de T selon l'une quelconque des revendications précédentes, les matériaux de blindage présentant une pluralité de points de contacts, qui, lors de la liaison d'un dispositif de liaison à un dispositif de liaison conçu de manière respectivement complémentaire, entraînent une mise en contact mutuelle à faible distance et sensiblement sur toute la longueur entre deux matériaux de blindage.

4. Connecteur de bus en forme de T selon l'une quelconque des revendications précédentes, le premier ou le deuxième dispositif de liaison étant une réglette de fiches ou une réglette de jacks électro-conductrice et le troisième dispositif de liaison étant une réglette de fiches ou de jacks électro-conductrice.

5. Connecteur de bus en forme de T selon l'une quelconque des revendications précédentes, le dispositif de support étant un rail de support (300) et le dispositif de retenue comprenant au moins deux crochets d'encliquetage à ressort permettant la retenue mobile et à nouveau libérable du connecteur sur le rail de support.

6. Connecteur de bus en forme de T selon l'une quelconque des revendications précédentes, les lignes de bus de la carte de circuits imprimés fournissant des lignes de bus de données, qui, lorsqu'une pluralité de connecteurs de bus en forme de T selon l'une quelconque des revendications précédentes sont juxtaposés au moyen de liaison par l'intermédiaire de respectivement des première et deuxième liaisons, guident des signaux de données entre les premier, deuxième et troisième dispositifs de liaison, de telle sorte que les signaux de données guidés par les lignes de bus de données s'appliquent respectivement contre ces trois dispositifs de liaison, s'appliquent respectivement contre les troisièmes dispositifs de liaison d'un groupe de connecteurs de bus en juxtaposition directe, s'appliquent respectivement contre les troisièmes dispositifs de liaison de deux connecteurs de bus en juxtaposition directe et relient ces derniers sous forme d'une « connexion en série » et/ou bien pontent un ou plusieurs de troisièmes dispositifs de liaison de connecteurs de bus juxtaposés.

7. Connecteur de bus en forme de T selon l'une quelconque des revendications précédentes, ces trois dispositifs de liaison (102, 103 et 104) étant rectangulaires et étant entièrement blindés au moyen d'une tôle de blindage au moins sur les respectivement deux plus grandes surfaces extérieures.

8. Connecteur de bus en forme de T selon l'une quelconque des revendications précédentes, les faces extérieures les plus courtes ou les faces extérieures les plus petites de ces trois dispositifs de liaison étant également pourvues de surfaces de blindage ou les broches des dispositifs de liaison disposées au voisinage de la face extérieure respectivement la plus courte étant garnies d'une masse ou d'un potentiel adapté ou les broches intérieures des dispositifs de liaison étant garnies d'une masse ou d'un potentiel adapté, lesquels entourent les broches pour guider les signaux de données.
